(19) Europäisches Patentamt
European Patent Office
Office européen des brevets

(11) EP 4 317 264 A1

(12) EUROPEAN PATENT APPLICATION
published in accordance with Art. 153(4) EPC

(43) Date of publication:
**07.02.2024 Bulletin 2024/06**

(21) Application number: **22780228.7**

(22) Date of filing: **18.03.2022**

(51) International Patent Classification (IPC):
***C08J 5/00*** *(2006.01)* ***C08K 3/04*** *(2006.01)*
***C08L 101/00*** *(2006.01)* ***H05K 9/00*** *(2006.01)*

(52) Cooperative Patent Classification (CPC):
**C08J 5/00; C08K 3/04; C08L 101/00; H05K 9/00**

(86) International application number:
**PCT/JP2022/012542**

(87) International publication number:
**WO 2022/210013 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **02.04.2021 JP 2021063752**

(71) Applicant: **Mitsubishi Chemical Corporation
Chiyoda-ku
Tokyo 100-8251 (JP)**

(72) Inventors:
- **ISEKI, Shuta
Hiratsuka-shi, Kanagawa 254-0016 (JP)**
- **SHOJI, Hidekazu
Hiratsuka-shi, Kanagawa 254-0016 (JP)**

(74) Representative: **Hoffmann Eitle
Patent- und Rechtsanwälte PartmbB
Arabellastraße 30
81925 München (DE)**

# (54) RESIN COMPOSITION AND MOLDED BODY

(57) To provide a resin composition and a molded article useful as a sub-millimeter wave controller. A resin composition contains a thermoplastic resin and an electrically conductive substance, wherein the resin composition formed into a molding with a size of 100 mm × 100 mm × t mm thick, provided that t is a value in the case where Concentration C (mass%) of an electrically conductive substance in the resin composition × Thickness t (mm) gives a value of 1.2 or more, has a Δ absorptance of 20.0% or less, which is the difference between the maximum value and the minimum value of the absorptance in the frequency range of 28.0 GHz to 40.0 GHz; and has the absorptance of 35.0% or more at a frequency of 28.0 GHz:

EP 4 317 264 A1

## Description

[Technical Field]

The present invention relates to a resin composition and a molded article. The present invention relates particularly to a resin composition excellent in electromagnetic wave absorbability in the sub-millimeter wave region.

[Background Art]

The fifth generation communication, which uses electromagnetic waves in the sub-millimeter wave region with frequencies of 20 to 30 GHz, enables large-capacity, low-delay telecommunications, and application thereof to autonomous and remote driving of automobiles has been studied.
For example, in Patent Literature 1, disclosed is an electromagnetic wave absorbing material usable from the sub-millimeter wave region to the millimeter wave region, which has excellent radio wave absorbability and is easy to manufacture. Along with development of the fifth generation mobile communication system (5G), the need for radar in the sub-millimeter wave region is also expanding.

[Citation List]

[Patent Literature]

[Patent Literature 1]
Japanese Patent Laid-Open No. 2003-243878

[Summary of Invention]

[Technical Problem]

Here, in advanced telecommunication using electromagnetic waves in the sub-millimeter wave region, interference due to noise electromagnetic waves generated around communication equipment is a cause of obstruction of normal communication. Further, electromagnetic waves for communication interfere with peripheral equipment to cause major malfunctions. Therefore, a sub-millimeter wave controller is required.
In order to solve such a problem, an object of the present invention is to provide a resin composition and a molded article useful as a sub-millimeter wave controller.

[Solution to Problem]

The present inventors conducted research to address the above-mentioned problems, and as a result, discovered that a resin composition is useful as a sub-millimeter wave controller by using the resin composition meeting a predetermined value.
Specifically, the problems described above are solved by the following means.

<1> A resin composition comprising a thermoplastic resin and an electrically conductive substance, wherein the resin composition formed into a molded article with a size of 100 mm × 100 mm × t mm thick, provided that t is a value in a case where Concentration C (mass%) of an electrically conductive substance in the resin composition × Thickness t (mm) gives a value of 1.2 or more, has a Δ absorptance of 20.0% or less, which is a difference between a maximum value and a minimum value of the absorptance determined according to formula (A) in the frequency range of 28.0 GHz to 40.0 GHz; and has the absorptance of 35.0% or more at a frequency of 28.0 GHz determined according to the formula (A):

Formula (A)

$$\text{Absorptance (\%)} = 100 - \left(\frac{1}{10^{-R/10}} \times 100 + \frac{1}{10^{-T/10}} \times 100\right)$$

wherein R represents the reflection loss measured by a free space method, and T represents the transmission loss measured by a free space method.

<2> The resin composition according to <1>,

wherein the resin composition formed into a molded article with a size of 100 mm × 100 mm × t mm thick, provided that t is a value in a case where Concentration C (mass%) of an electrically conductive substance in the resin composition × Thickness t (mm) gives a value of 1.2 or more, has a Δ reflectance of 20.0% or less, which is a difference between a maximum value and a minimum value of the reflectance determined according to formula (B) in the frequency range of 28.0 GHz to 40.0 GHz:

Formula (B)

$$\text{Reflectance (\%)} = \frac{1}{10^{-R/10}} \times 100$$

wherein R represents the reflection loss measured by a free space method.

<3> The resin composition according to <1> or <2>, wherein the resin composition formed into a molded article with a size of 100 mm × 100 mm × t mm thick, provided that t is a value in a case where Concentration C (mass%) of an electrically conductive substance in the resin composition × Thickness t (mm) gives a value of 1.2 or more, has a reflectance of 40.0% or less determined according to formula (B) at a frequency of 28.0 GHz:

Formula (B)

$$\text{Reflectance (\%)} = \frac{1}{10^{-R/10}} \times 100$$

wherein R represents the reflection loss measured by a free space method.
<4> The resin composition according to any one of <1> to <3>, wherein the resin composition formed into a molded article with a size of 100 mm × 100 mm × t mm thick, provided that t is a value in a case where Concentration C (mass%) of an electrically conductive substance in the resin composition × Thickness t (mm) gives a value of 1.2 or more, has a transmittance of 21.0% or less determined according to formula (C) at a frequency of 28.0 GHz:

Formula (C)

$$\text{Transmittance (\%)} = \frac{1}{10^{-T/10}} \times 100$$

provided that t represents the transmission loss measured by a free space method.
<5> The resin composition according to any one of <1> to <4>, wherein the absorptance is 40.0% or more determined according to formula (A) at a frequency of 28.0 GHz.
<6> The resin composition according to any one of <1> to <5>, wherein the electrically conductive substance comprises a carbon nanotube.
<7> The resin composition according to any one of <1> to <6>, wherein the thermoplastic resin comprises at least one selected from the group consisting of a polyester resin, a polycarbonate resin and a polystyrene-based resin.
<8> The resin composition according to any one of <1> to <6>, wherein the thermoplastic resin comprises a polybutylene terephthalate resin.
<9> The resin composition according to any one of <1> to <8>, wherein a part of the thermoplastic resin is derived from a masterbatch of the electrically conductive substance.
<10> The resin composition according to <9>, wherein the thermoplastic resin derived from the masterbatch comprises at least one selected from the group consisting of a polyester resin and a polystyrene-based resin.
<11> The resin composition according to any one of <1> to <10>, wherein the concentration of the electrically conductive substance in the resin composition is 0.01 to 10.0 mass%.
<12> The resin composition according to any one of <1> to <11>, further comprising a reinforcing material at ratio of 5.0 to 60.0 mass%.
<13> The resin composition according to any one of <1> to <12>, further comprising a reactive compound at ratio of 0.1 to 10.0 mass%.

<14> The resin composition according to any one of <1> to <13>, wherein the resin composition formed into a molded article with a size of 100 mm × 100 mm × t mm thick, provided that t is a value in a case where Concentration C (mass%) of an electrically conductive substance in the resin composition × Thickness t (mm) gives a value of 3.0 to 6.0, has a Δ absorptance of 20.0% or less, which is a difference between a maximum value and a minimum value of the absorptance determined according to formula (A) in the frequency range of 28.0 GHz to 40.0 GHz, and an absorptance of 35.0% or more at a frequency of 28.0 GHz determined according to the formula (A).
<15> The resin composition according to any one of <1> to <14>, for use in a sub-millimeter wave controller.
<16> A resin composition for a sub-millimeter wave controller comprising at least one thermoplastic resin selected from the group consisting of a polyester resin, a polycarbonate resin and a polystyrene-based resin, a carbon nanotube, and a reinforcing material, wherein a content of the carbon nanotube is 0.4 to 5.0 mass%.
<17> A molded article formed from the resin composition according to any one of <1> to <16>.
<18> The molded article according to <17>, which is for a sub-millimeter wave controller.

[Advantageous Effects of Invention]

The present invention enables a resin composition and a molded article that are useful as sub-millimeter wave controller to be provided.

[Description of Embodiment]

Hereinafter, the embodiment of the present invention (hereinafter, referred to simply as "present embodiment") is described in detail. The present embodiment described below is an example for describing the present invention, and the present invention is not limited only to the present embodiment.
In the present specification, the term "to" is used to include that the prefix and postfix numerical values thereof as the lower limit and the upper limit.
In the present specification, various physical properties and characteristic values are ones at 23°C, unless otherwise specified.
In the present specification, the weight average molecular weight and the number average molecular weight are in terms of polystyrene, as measured by GPC (gel permeation chromatography).
In the present specification, the unit for reflection loss and transmission loss is "dB" (decibel).
In the present specification, the sub-millimeter waves refer to electromagnetic waves having a frequency of 20.0 GHz to 40.0 GHz, and particularly refer to electromagnetic waves in a frequency range of 20.0 GHz to 30.0 GHz.
The resin composition of the present embodiment is a resin composition containing a thermoplastic resin and an electrically conductive substance, wherein the resin composition formed into a molded article with a size of 100 mm × 100 mm × t mm thick, provided that t is a value in the case where Concentration C (mass%) of an electrically conductive substance in the resin composition × Thickness t (mm) gives a value of 1.2 or more, has a Δ absorptance of 20.0% or less, which is the difference between the maximum value and the minimum value of the absorptance determined according to formula (A) in the frequency range of 28.0 GHz to 40.0 GHz, and has an absorptance of 35.0% or more at a frequency of 28.0 GHz determined according to the formula (A). With such a configuration, a resin composition useful as sub-millimeter wave controller can be provided.

Formula (A)

$$\text{Absorptance (\%)} = 100 - \left(\frac{1}{10^{-R/10}} \times 100 + \frac{1}{10^{-T/10}} \times 100\right)$$

wherein R represents the reflection loss measured by a free space method, and T represents the transmission loss measured by a free space method.
A sub-millimeter wave controller for use is required to have a high absorptance of electromagnetic waves near a frequency of 28.0 GHz among the sub-millimeter waves. In addition, with a large difference between the maximum absorptance and the minimum absorptance (Δ absorptance) in the sub-millimeter wave region, the quality stability of the controller is hardly maintained. In the present embodiment, the Δ absorptance in the sub-millimeter wave region is reduced to solve the problem.
Examples of the method for increasing the electromagnetic wave absorptance in the sub-millimeter wave region include increasing the relative concentration of an electrically conductive substance and increasing the relative thickness of a molded article. In other words, it has been found that a sub-millimeter wave controller having a value (Concentration C (mass%) of electrically conductive substance in resin composition × Thickness t (mm)) of 1.2 or more exhibits sufficient

performance. On the other hand, examples of the means for reducing the Δ absorptance in the sub-millimeter wave region while satisfying the condition (Concentration C (mass%) × Thickness t (mm)) include adjusting the types and combinations of the thermoplastic resin and the electrically conductive substance, adjusting the amount of electrically conductive substance added, and adjusting the method for adding the electrically conductive substance to the thermoplastic resin (for example, blending into a masterbatch). Here, the masterbatch means a pellet-shaped one in which a high concentration of electrically conductive substance is kneaded into a thermoplastic resin.

<Thermoplastic resin>

The resin composition of the present embodiment contains a thermoplastic resin.

Preferred examples of the thermoplastic resins used in the present embodiment include polyester resins (thermoplastic polyester resins); polyamide resins; polycarbonate resins; polystyrene-based resins; polyolefin resins such as polyethylene resins, polypropylene resins and cyclic cycloolefin resins; polyacetal resins; polyimide resins; polyetherimide resin; polyurethane resin; polyphenylene ether resins; polyphenylene sulfide resins; polysulfone resins; and polymethacrylate resins.

In an embodiment A of the thermoplastic resins in the resin composition of the present embodiment, at least one of a polyester resin, a polyamide resin, a polycarbonate resin, a polyphenylene ether resin and a polystyrene-based resin is included. Containing at least one selected from a polyester resin, a polycarbonate resin and a polystyrene-based resin is preferred, containing at least a polyester resin is more preferred, and containing at least a polybutylene terephthalate resin is still more preferred.

These resin components are usually the main component of the resins contained in the resin composition. Therefore, in particular, the content of the thermoplastic resin in an embodiment A (total amount, in the case of containing two or more types) is preferably 50 to 100 mass% of the resin components contained in the resin composition, and more preferably 60 to 99.9 mass%.

It is also preferred that a part of the thermoplastic resins contained in the resin composition of the present embodiment be derived from a masterbatch of an electrically conductive substance. The preparation of the masterbatch of the electrically conductive substance allows the dispersibility of the electrically conductive substance in the resin composition (particularly in the embodiment A of the thermoplastic resin) to be more improved, and the electromagnetic wave absorptance of the resulting resin composition or molded article to be more improved.

In an embodiment B of the thermoplastic resin in the resin composition of the present embodiment, the thermoplastic resin is preferably used as a resin derived from the masterbatch of an electrically conductive substance, which specifically contains preferably at least one selected from a polyester resin and a polystyrene-based resin. The content of the thermoplastic resin in the embodiment B (total amount, in the case of containing two or more types) is preferably 50 mass% or less, more preferably 30 mass% or less, still more preferably 25 mass% or less, furthermore preferably 20 mass% or less, and furthermore preferably 15 mass% or less of the resin components contained in the resin composition. Further, the content is preferably 0.1 mass% or more, more preferably 0.5 mass% or more, still more preferably 1.0 mass% or more, furthermore preferably 2.0 mass% or more, and furthermore preferably 3.0 mass% or more.

Each of the thermoplastic resins are described in more detail as follows.

<<Polyester resin>>

As the polyester resin, a known thermoplastic polyester resin may be used. A polyethylene terephthalate resin and a polybutylene terephthalate resin are preferred, and containing at least a polybutylene terephthalate resin is more preferred.

The polybutylene terephthalate resin for use in the resin composition of the present embodiment is a polyester resin having a structure with a terephthalic acid unit ester-bonded to a 1,4-butanediol unit, including in addition to a polybutylene terephthalate resin (homopolymer), a polybutylene terephthalate copolymer containing copolymer components other than the terephthalic acid unit and 1,4-butanediol unit, and a mixture of a homopolymer and a polybutylene terephthalate copolymer.

The polybutylene terephthalate resin may contain one or more dicarboxylic acid units other than terephthalic acid.

Specific examples of the other dicarboxylic acids include aromatic dicarboxylic acids such as isophthalic acid, orthophthalic acid, 1,5-naphthalene dicarboxylic acid, 2,5-naphthalene dicarboxylic acid, 2,6-naphthalene dicarboxylic acid, biphenyl-2,2'-dicarboxylic acid, biphenyl-3,3'-dicarboxylic acid, biphenyl-4,4'-dicarboxylic acid, bis(4,4'-carboxyphenyl)methane, anthracene dicarboxylic acid, and 4,4'-diphenyl ether dicarboxylic acid, alicyclic dicarboxylic acids such as 1,4-cyclohexane dicarboxylic acid and 4,4'-dicyclohexyl dicarboxylic acid, and aliphatic dicarboxylic acids such as adipic acid, sebacic acid, azelaic acid, and a dimer acid.

In the polybutylene terephthalate resin for use in the present embodiment, the terephthalic acid unit content in

the entire dicarboxylic acid units is preferably 80 mol% or more, more preferably 90 mol% or more.

The diol unit may contain one or more diol units in addition to 1,4-butanediol.

Specific examples of the other diol units include aliphatic or alicyclic diols having 2 to 20 carbon atoms and bisphenol derivatives. Specific examples include ethylene glycol, propylene glycol, 1,5-pentanediol, 1,6-hexanediol, neopentyl glycol, decamethylene glycol, cyclohexane dimethanol, 4,4'-dicyclohexylhydroxymethane, 4,4'-dicyclohexylhydroxypropane, and ethylene oxide addition diol of bisphenol A. In addition to the bifunctional monomers described above, a small amount of trimellitic acid, trimesic acid, pyromellitic acid, or pentaerythritol for introducing a branched structure, trifunctional monomers such as trimethylolpropane, and monofunctional compounds such as fatty acids for molecular weight adjustment may be also used in combination.

In the polybutylene terephthalate resin for use in the present embodiment, the 1,4-butanediol unit content in the entire diol units is preferably 80 mol% or more, more preferably 90 mol% or more.

As described above, it is preferable that the polybutylene terephthalate resin be a polybutylene terephthalate homopolymer obtained by polycondensation of terephthalic acid and 1,4-butanediol. Alternatively, the polybutylene terephthalate copolymer may contain one or more dicarboxylic acids other than the terephthalic acid as carboxylic acid units and/or one or more diols other than the 1,4-butanediol as diol units. In the case where the polybutylene terephthalate resin is a polybutylene terephthalate resin modified by copolymerization, specific examples of the preferred copolymers include polyester ether resins obtained by copolymerizing polyalkylene glycols, particularly polytetramethylene glycol, dimer acid-copolymerized polybutylene terephthalate resins, and isophthalic acid-copolymerized polybutylene terephthalate resin. In particular among them, it is preferable to use polyester ether resins obtained by copolymerizing polytetramethylene glycol.

Incidentally, these copolymers refer to those having a copolymerization amount of 1 mol% or more and less than 50 mol% in all the segments of the polybutylene terephthalate resin. In particular, the copolymerization amount is preferably 2 mol% or more and less than 50 mol%, more preferably 3 to 40 mol%, and still more preferably 5 to 20 mol%. With such a copolymerization ratio, the fluidity, toughness, and tracking resistance tend to be preferably improved.

The amount of the terminal carboxyl group in the polybutylene terephthalate resin may be appropriately selected and determined to be usually 60 eq/ton or less, preferably 50 eq/ton or less, and more preferably 30 eq/ton or less. With an amount equal to or less than the upper limit, the alkali resistance and hydrolysis resistance tend to be improved. The lower limit of the amount of the terminal carboxyl group is not particularly specified, and usually 10 eq/ton or more in consideration of productivity of the polybutylene terephthalate resin.

The amount of terminal carboxyl group in the polybutylene terephthalate resin is a value measured by dissolving 0.5 g of polybutylene terephthalate resin in 25 mL of benzyl alcohol and titrating with 0.01 mol/L sodium hydroxide benzyl alcohol solution. As a method for adjusting the amount of the terminal carboxyl groups, any conventionally known method such as a method of adjusting polymerization conditions such as the raw material charge ratio, the polymerization temperature, and a decompression method during polymerization, and a method for reacting with a terminal blocking agent.

It is preferable that the intrinsic viscosity of the polybutylene terephthalate resin be 0.5 to 2 dL/g. From the viewpoints of moldability and mechanical properties, those having an intrinsic viscosity in the range of 0.6 to 1.5 dL/g are more preferred. With an intrinsic viscosity controlled to 0.5 dL/g or more, the mechanical strength of the resulting resin composition tends to be more improved. With an intrinsic viscosity controlled to 2 dL/g or less, the fluidity of the resin composition tends to be more improved, and the moldability tends to be improved.

The intrinsic viscosity of the polybutylene terephthalate resin is a value measured at 30°C in a mixed solvent of tetrachloroethane and phenol at a mass ratio of 1:1.

The polybutylene terephthalate resin may be produced by melt-polymerizing dicarboxylic acid components mainly composed of terephthalic acid or an ester derivative thereof and diol components mainly composed of 1,4-butanediol in a batch or continuous method. Further, after producing a polybutylene terephthalate resin having a low molecular weight by melt polymerization, the degree of polymerization (or molecular weight) may be increased to a desired value by solid-phase polymerization under a nitrogen stream or under reduced pressure.

It is preferable that the polybutylene terephthalate resin be produced by continuous melt polycondensation of a dicarboxylic acid component mainly composed of terephthalic acid and a diol component mainly composed of 1,4-butanediol.

The catalyst used for the esterification reaction may be a conventionally known one, and examples thereof include titanium compounds, tin compounds, magnesium compounds, and calcium compounds. In particular among these, titanium compounds are preferred. Specific examples of the titanium compounds as the esterification catalyst include titanium alcoholates such as tetramethyl titanate, tetraisopropyl titanate and tetrabutyl titanate, and titanium phenolates such as tetraphenyl titanate.

As for the polyester resin, in addition to the above, the descriptions in paragraphs 0013 to 0016 of Japanese Patent Laid-Open No. 2010-174223 may be referred to, and the content thereof is incorporated herein.

<<Polystyrene-based resin>>

Examples of the polystyrene-based resins include homopolymers of styrene-based monomers, and copolymers of a styrene-based monomer and a monomer copolymerizable with the styrene-based monomer. Examples of the styrene-based monomers include styrene, $\alpha$-methylstyrene, chlorostyrene, methylstyrene, and tert-butylstyrene. In the polystyrene-based resin in the present embodiment, 50 mol % or more of the monomer units are styrene-based monomers.

More specific examples of the polystyrene-based resins include resins such as polystyrene resins, acrylonitrile-styrene copolymers (AS resins), highly impact-resistant polystyrene resins (HIPS), acrylonitrile-butadiene-styrene copolymers (ABS resins), acrylonitrile-acrylic rubber-styrene copolymers (AAS resins), acrylonitrile-styrene-acrylic rubber copolymers (ASA resins), acrylonitrile-ethylene propylene-based rubber-styrene copolymers (AES resins), and styrene-IPN type rubber copolymers.

In the present embodiment, the polystyrene-based resins are preferably acrylonitrile-styrene copolymers (AS resins), highly impact-resistant polystyrene resins (HIPS), acrylonitrile-butadiene-styrene copolymers (ABS resins), acrylonitrile-acrylic rubber-styrene copolymers (AAS resins), acrylonitrile-styrene-acrylic rubber copolymers (ASA resins), acrylonitrile-ethylene propylene-based rubber-styrene copolymers (AES resins), and styrene-IPN type rubber copolymer are preferred, highly impact-resistant polystyrene resins (HIPS) are more preferred, and butadiene rubber-containing polystyrenes are still more preferred.

In the case where the polystyrene-based resin contains a rubber component, the rubber component content in the polystyrene-based resin is preferably 3 to 70 mass%, more preferably 5 to 50 mass%, and still more preferably 7 to 30 mass%. With a rubber component content of 3 mass% or more, the impact resistance tends to be improved, and with a content of 50 mass% or less, the flame retardancy tends to be preferably improved. Further, the average particle size of the rubber component is preferably 0.05 to 10 $\mu$m, more preferably 0.1 to 6 $\mu$m, and still more preferably 0.2 to 3 $\mu$m. With an average particle size of 0.05 $\mu$m or more, the impact resistance tends to be improved, and with an average particle size of 10 $\mu$m or less, the appearance tends to be preferably improved.

The weight average molecular weight (Mw) of the polystyrene-based resin is usually 50000 or more, preferably 100000 or more, more preferably 150000 or more, and usually 500000 or less, preferably 400000 or less, more preferably 300000 or less. Further, the number average molecular weight (Mn) is usually 10000 or more, preferably 30000 or more, more preferably 50000 or more, and preferably 500000 or less, more Preferably 300000 or less.

The melt flow rate (MFR) of the polystyrene-based resin measured according to JIS K7210 (temperature: 200°C, load: 5 kgf) is preferably 0.1 to 30 g/10 minutes, and more preferably 0.5 to 25 g/10 minutes. With an MFR of 0.1 g/10 minutes or more, the fluidity tends to be improved, and with an MFR of 30 g/10 minutes or less, the impact resistance tends to be improved.

Examples of the methods for producing the polystyrene-based resins include known methods such as emulsion polymerization, solution polymerization, suspension polymerization, and bulk polymerization.

<<Polycarbonate resin>>

The polycarbonate resin is an optionally branched homopolymer or copolymer obtained by reacting a dihydroxy compound or a dihydroxy compound plus a small amount of a polyhydroxy compound with phosgene or a carbonic acid diester. The method for producing the polycarbonate resin is not particularly limited, and one produced by a conventionally known phosgene method (interfacial polymerization method) or melting method (transesterification method) may be used.

The dihydroxy compound as raw material is preferably an aromatic dihydroxy compound. Examples thereof include 2,2-bis(4-hydroxyphenyl)propane (=bisphenol A), tetramethyl bisphenol A, bis(4-hydroxyphenyl)-p-diisopropylbenzene, hydroquinone, resorcinol, and 4,4-dihydroxydiphenyl, and bisphenol A is preferred. A compound including one or more tetraalkyl phosphonium sulfonates bonded to the aromatic dihydroxy compound may be also used.

Among the polycarbonate resins described above, aromatic polycarbonate resins derived from 2,2-bis(4-hydroxyphenyl)propane, or aromatic polycarbonate copolymers derived from 2,2-bis(4-hydroxyphenyl)propane and other aromatic dihydroxy compounds are preferred. Alternatively, a copolymer mainly composed of an aromatic polycarbonate resin such as a copolymer including a polymer or oligomer having a siloxane structure may be employed. Furthermore, two or more of the polycarbonate resins described above may be mixed for use.

In order to adjust the molecular weight of polycarbonate resins, a monohydric aromatic hydroxy compound may be used, and examples thereof include m- and p-methyl phenols, m- and p-propyl phenols, p-tert-butyl phenol, and p-long-chain alkyl substituted phenols.

The polycarbonate resin has a viscosity-average molecular weight (Mv) of preferably 5000 or more, more preferably 10000 or more, and still more preferably 13000 or more. With use of those having a viscosity average molecular weight of 5000 or more, the mechanical strength of the resulting resin composition tends to be further improved. The polycarbonate resin has a viscosity-average molecular weight (Mv) of preferably 60000 or less, more preferably 40000

or less, and still more preferably 30000 or less. With use of those having a viscosity average molecular weight of 60000 or less, the fluidity of the resin composition is improved, so that the moldability tends to be improved.

In the case where two or more types of polycarbonate resins are included, it is preferable that the mixture satisfies the ranges described above. (In the following, the same consideration applies to the molecular weight.)

In the present embodiment, the viscosity average molecular weight (Mv) of the polycarbonate resin is a value obtained from the calculation of the following Schnell viscosity equation based on the measurement of the viscosity of a methylene chloride solution of the polycarbonate resin at 20°C using an Ubbelohde viscometer to determine the intrinsic viscosity ([η]).

$$[\eta]=1.23\times10^{-4}Mv^{0.83}$$

The method for producing the polycarbonate resin is not particularly limited, and polycarbonate resins produced by any of the phosgene method (interfacial polymerization method) or the melt method (transesterification method) may be used. Further, a polycarbonate resin prepared by subjecting the polycarbonate resin produced by a melting method to a post-treatment for adjusting the amount of terminal OH groups is also preferred.

<<Polyphenylene ether resin>>

In the present embodiment, a known polyphenylene ether resin may be used, and examples thereof include a polymer having a structural unit represented by the following formula in the main chain (preferably, a polymer having a structural unit represented by the following formula in an amount of 90 mol % or more in all structural units excluding terminal groups). Polyphenylene ether resins may be either homopolymers or copolymers.

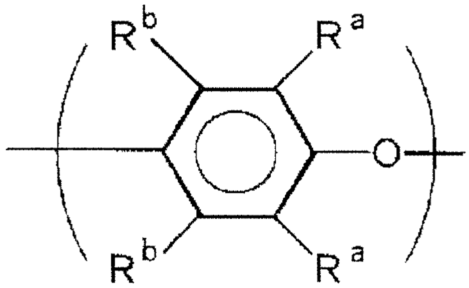

wherein two $R^a$ each independently represent a hydrogen atom, a halogen atom, a primary or secondary alkyl group, an aryl group, an aminoalkyl group, a halogenated alkyl group, a hydrocarbonoxy group, or a halogenated hydrocarbonoxy group, and two $R^b$ each independently represent a hydrogen atom, a halogen atom, a primary or secondary alkyl group, an aryl group, a halogenated alkyl group, a hydrocarbonoxy group, or a halogenated hydrocarbonoxy group, provided that both of the two $R^a$ are not hydrogen atoms in parallel.

It is preferable that $R^a$ and $R^b$ be each independently a hydrogen atom, a primary or secondary alkyl group, or an aryl group. Preferred examples of the primary alkyl group include a methyl group, an ethyl group, an n-propyl group, an n-butyl group, an n-amyl group, an isoamyl group, a 2-methylbutyl group, a 2,3-dimethylbutyl group, and a 2-, 3- or 4-methylpentyl group and a heptyl group. Preferred examples of the secondary alkyl group include an isopropyl group, a sec-butyl group, and a 1-ethylpropyl group. It is particularly preferable that $R^a$ be a primary or secondary alkyl group having 1 to 4 carbon atoms or a phenyl group. It is preferable that $R^b$ be a hydrogen atom.

Examples of the suitable polyphenylene ether resin homopolymers include 2,6-dialkylphenylene ether polymers such as poly(2,6-dimethyl-1,4-phenylene)ether, poly(2,6-diethyl-1,4-phenylene ether), poly(2, 6-dipropyl-1,4-phenylene ether), poly(2-ethyl-6-methyl-1,4-phenylene ether), and poly(2-methyl-6-propyl-1,4-phenylene ether). Examples of the copolymers include 2,6-dialkylphenol/2,3,6-trialkylphenol copolymers such as 2,6-dimethylphenol/2,3,6-trimethylphenol copolymer, 2,6-dimethylphenol/2,3,6-triethylphenol copolymer, 2,6-diethylphenol/2,3,6-trimethylphenol copolymer, 2,6-dipropylphenol/2,3,6-trimethylphenol copolymer, graft copolymers obtained by grafting styrene to poly(2,6-dimethyl-1,4-phenylene ether), and graft copolymers obtained by graft polymerizing styrene to 2,6-dimethylphenol/2,3,6-trimethylphenol copolymer.

As the polyphenylene ether resin in the present embodiment, poly(2,6-dimethyl-1,4-phenylene)ether and 2,6-dimethylphenol/2,3,6-trimethylphenol random copolymer are particularly preferred. Alternatively, polyphenylene ether resins having a specified number of terminal groups and a specified copper content as described in Japanese Patent Laid-Open No. 2005-344065 may be preferably used.

The polyphenylene ether resin has an intrinsic viscosity at 30°C measured in chloroform of preferably 0.2 to 0.8 dL/g, more preferably 0.3 to 0.6 dL/g. With an intrinsic viscosity controlled to 0.2 dL/g or more, the mechanical strength of a molded article tends to be more improved, and with an intrinsic viscosity controlled to 0.8 dL/g or less, the fluidity of the resin composition is more improved, so that forming tends to be easier. Alternatively, two or more polyphenylene ether resins having a different intrinsic viscosity may be used in combination to obtain the range of the intrinsic viscosity.
The method for producing the polyphenylene ether resin used in the present embodiment is not particularly limited, and according to a known method, for example, a monomer such as 2,6-dimethylphenol may be oxidatively polymerized in the presence of an amine copper catalyst, under reaction conditions selected to control the intrinsic viscosity to the desired range. The control of intrinsic viscosity may be achieved by selecting conditions such as polymerization temperature, polymerization time, and amount of catalyst.

<<Polyamide resin>>

The polyamide resin is a polymer having a structural unit of acid amide obtained by ring-opening polymerization of a lactam, polycondensation of an amino carboxylic acid, or polycondensation of a diamine and a dibasic acid, which may be an aliphatic polyamide resin or a semi-aromatic polyamide resin.
Specific examples thereof include polyamides 6, 11, 12, 46, 66, 610, 612, 6I, 6/66, 6T/6I, 6/6T, 66/6T, 66/6T/6I, 9T and 10T, a xylylene diamine-based polyamide resin described in detail in the following, polytrimethyl hexamethylene terephthalamide, polybis(4-aminocyclohexyl)methane dodecanamide, polybis(3-methyl-4-aminocyclohexyl)methane dodecanamide, and polyundecamethylene hexahydro terephthalamide. Incidentally, in the above, "I" represents an isophthalic acid component, and "T" represents a terephthalic acid component. As the polyamide resin, the description in paragraphs 0011 to 0013 of Japanese Patent Laid-Open No. 2011-132550 may be referred to, and the content thereof is incorporated herein.
The polyamide resin used in the present embodiment includes a diamine-derived structural unit and a dicarboxylic acid-derived structural unit, being preferably a xylylene diamine-based polyamide resin with a xylene diamine-derived structural unit content of 50 mol% or more in the diamine-derived structural unit. The xylylene diamine-based polyamide resin includes diamine-derived structural units with a content of at least one of meta-xylylene diamine and para-xylylene diamine of preferably 70 mol% or more, more preferably 80 mol% or more, still more preferably 90 mol% or more, and furthermore preferably 95 mol% or more. The xylylene diamine-based polyamide resin includes dicarboxylic acid-derived structural units with a content of $\alpha,\omega$-straight-chain aliphatic dibasic acids having 4 to 20 carbon atoms of preferably 50 mol% or more, more preferably 70 mol% or more, still more preferably 80 mol% or more, furthermore preferably 90 mol% or more, and furthermore preferably 95 mol% or more. As the $\alpha,\omega$-straight-chain aliphatic dicarboxylic acids having 4 to 20 carbon atoms, adipic acid, sebacic acid, suberic acid, dodecanedioic acid, and eicodioic acid may be preferably used, and adipic acid and sebacic acid are more preferred.
Examples of the diamines other than meta-xylylene diamine and para-xylylene diamine which can be used as raw material diamine components for xylylene diamine-based polyamide resins include aliphatic diamines such as tetramethylene diamine, pentamethylene diamine, 2-methylpentane diamine, hexamethylenediamine, heptamethylene diamine, octamethylene diamine, nonamethylene diamine, decamethylene diamine, dodecamethylene diamine, 2,2,4-trimethylhexamethylene diamine, and 2,4,4-trimethylhexamethylene diamine, alicyclic diamines such as 1,3-bis(aminomethyl)cyclohexane, 1,4-bis(aminomethyl)cyclohexane, 1,3-diaminocyclohexane, 1,4-diaminocyclohexane, bis(4-aminocyclohexyl)methane, 2,2-bis(4-amino cyclohexyl)propane, bis(aminomethyl)decalin, and bis(aminomethyl)tricyclodecane, and diamines having an aromatic ring such as bis(4-aminophenyl)ether, paraphenylenediamine, bis(aminomethyl)naphthalene, and one or a mixture of two or more thereof may be used.
Examples of the dicarboxylic acid components other than the $\alpha,\omega$-straight-chain aliphatic dicarboxylic acids having 4 to 20 carbon atoms include phthalic acid compounds such as isophthalic acid, terephthalic acid and orthophthalic acid, naphthalene dicarboxylic acid isomers such as 1,2-naphthalene dicarboxylic acid, 1,3-naphthalene dicarboxylic acid, 1,4-naphthalene dicarboxylic acid, 1,5-naphthalene dicarboxylic acid, 1,6-naphthalene dicarboxylic acid, 1,7-naphthalene dicarboxylic acid, 1,8-naphthalene dicarboxylic acid, 2,3-naphthalene dicarboxylic acid, 2,6-naphthalene dicarboxylic acid, and 2,7-naphthalene dicarboxylic acid, and one or a mixture of two or more thereof may be used.
The content of the thermoplastic resin in the resin composition of the present embodiment is preferably 30 mass% or more, more preferably 35 mass% or more, still more preferably 40 mass% or more, furthermore preferably 45 mass% or more, furthermore preferably 50 mass% or more, furthermore preferably 55 mass or more, and may be 60 mass% or more. With a content equal to or more than the lower limit, the fluidity during injection molding tends to be more improved. The content of the thermoplastic resin in the resin composition is more preferably 90 mass% or less, still more preferably 85 mass% or less, and furthermore preferably 80 mass% or less. With a content equal to or less than the upper limit, the mechanical strength of the resin is improved.
The resin composition of the present embodiment may contain only one type of thermoplastic resin, or may

contain two or more types. In the case where two or more types are included, it is preferable that the total content be within the range.

<Electrically conductive substance>

The resin composition of the present embodiment contains an electrically conductive substance. By containing an electrically conductive substance, electromagnetic wave absorbability can be imparted to the resin composition.

Examples of the electrically conductive substance used in the present embodiment include metals, metal oxides, electrically conductive carbon compounds and electrically conductive polymers, and electrically conductive carbon compounds are preferred.

Examples of the metals include copper, nickel, silver, and stainless steel, and metal fillers, stainless steel fibers, and magnetic fillers are preferred. Examples of the metal oxides include alumina and zinc oxide, and alumina fibers and zinc oxide nanotubes are preferred. Examples of the electrically conductive carbon compounds include carbon black, ketjen carbon, graphene, graphite, fullerene, carbon nanocoil, carbon nanotube, and carbon fiber are preferred, and carbon nanotube is more preferred.

Fibers coated with metals, metal oxides, or electrically conductive carbon compounds are also preferred. Examples thereof include carbon-coated potassium titanate whiskers and metal-coated fibers.

It is preferable that the electrically conductive substance in the present embodiment be in a relatively thin and long shape such as fibrous, tubular, or whisker-like shape.

The diameter (number average fiber diameter) of the electrically conductive substance is preferably 0.5 nm or more, more preferably 1 nm or more, still more preferably 3 nm or more, and preferably 50 μm or less, more preferably 20 μm or less, still more preferably 500 nm or less, and furthermore preferably 100 nm or less.

The aspect ratio of the electrically conductive substance is preferably 5 or more, more preferably 50 or more, from the viewpoint of imparting good electromagnetic wave absorbability. The upper limit of the aspect ratio is, for example, 500 or less, though not particularly specified.

Carbon nanotubes are preferred as the electrically conductive substance used in the present embodiment. The carbon nanotubes are single-layer carbon nanotubes and/or multi-layer carbon nanotubes, and preferably include at least a multi-layer carbon nanotube. A carbon material partially having a carbon nanotube structure may be also used. The carbon nanotube is not limited to a cylindrical shape, and may have a coiled shape spirally rounding at a pitch of 1 μm or less.

Carbon nanotubes are commercially available, and examples thereof include carbon nanotubes available from Bayer Material Science AG, Nanosil, Showa Denko K.K., or Hyperion Catalysis International Inc. Incidentally, the carbon nanotube may be also referred to as graphite fibril, carbon fibril, carbon nanostructure, or carbon nanofiber.

In the resin composition of the present embodiment, it is preferable that the electrically conductive substance be compounded with a thermoplastic resin (preferably the thermoplastic resin in the embodiment B described above) into a masterbatch. Making the masterbatch with a thermoplastic resin effectively improves the dispersibility of the electrically conductive substance in the thermoplastic resin as main component (preferably the thermoplastic resin in the embodiment A described above).

The concentration of the electrically conductive substance in the masterbatch is preferably 1 mass% or more, preferably 5 mass% or more, and preferably 98 mass% or less, more preferably 50 mass% or less, still more preferably 30 mass% or less, and furthermore preferably 20 mass% or less. With a content controlled in the range from the upper limit to the lower limit, the dispersibility of the electrically conductive substance into the thermoplastic resin tends to be more improved.

The content of the electrically conductive substance (preferably carbon nanotubes) in the resin composition of the present embodiment (the concentration of the electrically conductive substance in the resin composition) is preferably 0.01 mass% or more, more preferably 0.05 mass% or more, still more preferably 0.1 mass% or more, furthermore preferably 0.3 mass% or more, furthermore preferably 0.5 mass% or more, furthermore preferably 0.6 mass% or more, and furthermore preferably 1.0 mass% or more. With a content equal to or more than the lower limit, the electromagnetic wave absorbability is exhibited effectively. The content of the electrically conductive substance (preferably carbon nanotubes) in the resin composition of the present embodiment is preferably 10.0 mass% or less, more preferably 8.0 mass% or less, still more preferably 5.0 mass% or less, furthermore preferably 4.0 mass% or less, furthermore preferably 3.2 mass% or less, and furthermore preferably 3.0 mass% or less. With a content equal to or less than the upper limit, the fluidity of the resin tends to be more improved.

The resin composition of the present embodiment may contain only one type of electrically conductive substance, or may contain two or more types thereof. In the case where two or more types are included, it is preferable that the total content be within the range.

<Reinforcing material>

The resin composition of the present embodiment may contain a reinforcing material, and preferably contains the reinforcing material in a proportion of 5.0 to 60.0 mass% in the resin composition.
The type of the reinforcing material that can be used in the present embodiment is not particularly specified. Any of fibers, fillers, beads may be used, and fibers are preferred.
In the present invention, a substance categorized as the electrically conductive substance and also categorized as the reinforcing material is defined as an electrically conductive substance.
In the case where the reinforcing material is a fiber, it may be made of short fibers or long fibers.
In the case where the reinforcing material is made of short fibers, fillers, or beads, examples of the resin composition of the present embodiment include a pellet, a pulverized product of the pellet, and a film formed from the pellet.
In the case where the reinforcing material is made of long fibers, examples of the reinforcing material include long fibers for use as so-called UD (Uni-Directional) material, and long fibers in a sheet form such as woven fabric and knitted fabric. In the case of using these long fibers, components other than the reinforcing material of the resin composition of the present embodiment are impregnated into the long fibers in a sheet form as reinforcing material so as to make a resin composition in a sheet form (for example, a prepreg).
Examples of the raw materials for the reinforcing material include inorganic substances such as glass, carbon (carbon fiber, etc.), alumina, boron, ceramics, metals (steel, etc.), and organic substances such as plants (including Kenaf, bamboo, etc.), aramid, polyoxymethylene, aromatic polyamide, polyparaphenylene benzobisoxazole, and ultra-high molecular weight polyethylene, and glass is preferred.
It is preferable that the resin composition of the present embodiment contain glass fibers as reinforcing material.
The glass composition of the glass fibers is selected from A glass, C glass, E glass, R glass, D glass, M glass, and S glass, and E glass (alkali-free glass) is particularly preferred.
Glass fibers refer to a fibrous material having a true circular or polygonal cross-section when cut perpendicular to the length direction. The glass fibers include single fibers having a number average fiber diameter of usually 1 to 25 μm, preferably 5 to 17 μm. With a number average fiber diameter controlled to 1 μm or more, the moldability of the resin composition tends to be more improved. With a number average fiber diameter controlled to 25 μm or less, the appearance of the resulting molded article tends to be improved and the reinforcing effect tends to be also improved. The glass fibers may be made of a single fiber or a plurality of twisted single fibers.
The forms of glass fibers may be any of a glass roving obtained by continuously winding a single fiber or a plurality of twisted fibers, chopped strands cut to a length of 1 to 10 mm (i.e., glass fibers with a number average fiber length of 1 to 10 mm), and milled fibers pulverized to a length of about 10 to 500 μm (i.e., glass fibers having a number average fiber length of 10 to 500 μm), and chopped strands cut to a length of 1 to 10 mm are preferred. The glass fibers having a different form may be also used in combination.
As the glass fibers, ones having a variant cross-sectional shape are also preferred. The variant cross-sectional shape has an oblateness defined by the ratio of major axis to minor axis of a cross section perpendicular to the length direction of the fiber of, for example, 1.5 to 10, preferably 2.5 to 10, more preferably 5 to 8, and particularly preferably 2.5 to 5.
The glass fibers may be surface-treated with, for example, a silane-based compound, an epoxy-based compound, or a urethane-based compound, or may be oxidized, in order to improve the affinity with resin components as long as the properties of the resin composition of the present embodiment are not significantly impaired.
In the case where the resin composition of the present embodiment contains a reinforcing material (preferably a glass fibers), the content thereof is preferably 10 parts by mass or more, more preferably 20 parts by mass or more, still more preferably 30 parts by mass or more, and furthermore preferably 40 parts by mass or more, relative to 100 parts by mass of the thermoplastic resin. With a content equal to or more than the lower limit, the mechanical strength of the resulting molded article tends to be more increased. The content of the reinforcing material (preferably glass fibers) is preferably 100 parts by mass or less, more preferably 90 parts by mass or less, still more preferably 85 parts by mass or less, furthermore preferably 80 parts by mass or less, and furthermore preferably 75 parts by mass or less, relative to 100 parts by mass of the thermoplastic resin. With a content equal to or less than the upper limit, the appearance of the molded article tends to be improved and the fluidity of the resin composition tends to be more improved.
In the case where the resin composition of the present embodiment contains a reinforcing material (preferably glass fibers), the content thereof in the resin composition is preferably 5.0 mass% or more, more preferably 15.0 mass% or more, still more preferably 20.0 mass% or more, and furthermore preferably 25.0 mass% or more. With a content equal to or more than the lower limit, the mechanical strength of the resulting molded article tends to be more improved. With a content of the reinforcing material (preferably glass fibers) in the resin composition is preferably 60.0 mass% or less, more preferably 45.0 mass% or less, still more preferably 40.0 mass% or less, and furthermore preferably 35.0 mass% or less. With a content equal to or more than the lower limit, the mechanical strength tends to be more increased. With a content equal to or less than the upper limit, the appearance of a molded article tends to be improved and the

fluidity of the resin composition during melting tends to be more improved.

The resin composition of the present embodiment may contain only one reinforcing material (preferably glass fibers), or may contain two or more reinforcing materials. In the case where two or more types are included, it is preferable that the total content be within the range.

<Reactive compound>

The resin composition of the present embodiment may contain a reactive compound, and preferably contains the reactive compound in a proportion of 0.1 to 10.0 mass% in the resin composition. The reactive compound included results in an improved mechanical strength of a molded article, and excellent hydrolysis resistance of the resin composition.

The reactive compound used in the present embodiment preferably contains at least one selected from the group consisting of a compound having an epoxy group, a carbodiimide compound, a compound having an oxazoline group and a compound having an oxazine group, and more preferably contains a compound having an epoxy group.

<<Compound having epoxy group (epoxy resin)>>

The compound having an epoxy group is a compound having one or more epoxy groups in one molecule, and includes glycidyl compounds, aromatic ring-containing compounds having an epoxy group, and alicyclic compounds having an epoxy group. It is preferable that at least an aromatic ring-containing compound having an epoxy group be included.

Specific examples of the compounds having an epoxy group include epoxy compounds having an aromatic ring such as bisphenol A type epoxy compounds (including bisphenol A diglycidyl ether), bisphenol F type epoxy compounds (including bisphenol F diglycidyl ether), biphenyl type epoxy compounds (including bis(glycidyloxy)biphenyl), resorcinol type epoxy compounds (including resorcinol diglycidyl ether), novolac type epoxy compounds, benzoic acid glycidyl esters, terephthalic acid diglycidyl esters, and orthophthalic acid diglycidyl esters, (di)glycidyl ethers such as methyl glycidyl ether, butyl glycidyl ether, 2-ethylhexyl glycidyl ether, decyl glycidyl ether, stearyl glycidyl ether, phenyl glycidyl ether, butylphenyl glycidyl ether, allyl glycidyl ether, neopentyl glycol diglycidyl ether, ethylene glycol diglycidyl ether, glycerol diglycidyl ether, and propylene glycol diglycidyl ether, paraffin-based (e.g., saturated fatty acid-based) or olefin-based (e.g., unsaturated fatty acid-based) (di)glycidyl esters such as glycidyl sorbate, diglycidyl adipate, epoxidized linseed oil and epoxidized soybean oil, alicyclic epoxy compounds such as vinyl cyclohexene dioxide and dicyclopentadiene oxide, and epoxy-modified styrene-acrylic copolymers.

Among them, styrene-acrylic copolymers containing a glycidyl group in a side chain, bisphenol A type epoxy compounds, novolac type epoxy compounds, bisphenol F type epoxy compounds, and biphenyl type epoxy compounds are preferred, and bisphenol A type epoxy compounds are more preferred.

The content of the reactive compound (preferably, a compound having an epoxy group (epoxy resin)) in the resin composition of the present embodiment is preferably 0.1 mass% or more, more preferably 0.2 mass% or more, and still more preferably 0.3 mass% or more, in the resin composition. With a controlled content equal to or more than the lower limit, the hydrolysis resistance tends to be more improved. The content of the reactive compound (preferably, a compound having an epoxy group (epoxy resin)) is preferably 10.0 mass% or less, more preferably 5.0 mass% or less, still more preferably 3.0 mass% or less, and furthermore preferably 1.0 mass% or less, in the resin composition. With a controlled content equal to or less than the upper limit, the melt viscosity tends to be more stable and the moldability tends to be improved.

The resin composition of the present embodiment may contain only one reactive compound, or may contain two or more reactive compounds. In the case where two or more types are included, it is preferable that the total content be within the range.

<Other components>

The resin composition of the present embodiment may contain other components on an as needed basis in addition to those described above, as long as the desired physical properties are not significantly impaired. Examples of the other components include various resin additives. Only one type of the other components may be contained, or two or more types may be contained in any combination and at any ratio.

Specific examples thereof include stabilizers, release agents, pigments, dyes, ultraviolet absorbers, antistatic agents, antifogging agents, antiblocking agents, fluidity improvers, plasticizers, dispersants, and antibacterial agents. The resin composition of the present embodiment preferably contains at least one of a stabilizer and a release agent.

The resin composition of the present embodiment is adjusted such that the total content of a thermoplastic resin, an electrically conductive substance, and other optionally blended components is 100 mass%. In the resin composition of the present embodiment, it is preferable that the total content of a thermoplastic resin, an electrically conductive substance, and a reinforcing material optionally blended be 95 mass% or more in the resin composition. It is also preferable that in the resin composition of the present embodiment, the total content of a thermoplastic resin, an electrically conductive substance, a reinforcing material, a stabilizer, a release agent, and a reactive compound be 99 mass% or more in the resin composition.

<<Stabilizer>>

The resin composition of the present embodiment may contain a stabilizer. Examples of the stabilizers include hindered phenol-based compounds, hindered amine-based compounds, phosphorus-based compounds, and sulfur-based stabilizers. Among these, phosphorus-based compounds and sulfur-based stabilizers are preferred.
For specific stabilizers, the description in paragraphs 0046 to 0057 in Japanese Patent Laid-Open No. 2018-070722, the description in paragraphs 0030 to 0037 in Japanese Patent Laid-Open No. 2019-056035, and the description in paragraphs 0066 to 0078 in International Publication No. WO 2017/038949 may be referred to, and the contents thereof are incorporated herein.
In the resin composition of the present embodiment, the content of a stabilizer is preferably 0.01 parts by mass or more, more preferably 0.05 parts by mass or more, and still more preferably 0.08 parts by mass or more, relative to 100 parts by mass of the thermoplastic resin. The upper limit of the content of the stabilizer is preferably 3 parts by mass or less, more preferably 2 parts by mass or less, and still more preferably 1 part by mass or less, relative to 100 parts by mass of the thermoplastic resin.
The resin composition of the present embodiment may contain only one stabilizer, or may contain two or more stabilizers. In the case where two or more types are included, it is preferable that the total content be within the range.

<<Release agent>>

It is preferable that the resin composition of the present embodiment contain a release agent.
As the release agent, a wide range of known release agents may be used. An esterified aliphatic carboxylic acid, a paraffin wax and a polyethylene wax are preferred, and polyethylene wax is more preferred.
For specific release agents, the description in paragraphs 0115 to 0120 of Japanese Patent Laid-Open No. 2013-007058, the description in paragraphs 0063 to 0077 of Japanese Patent Laid-Open No. 2018-070722, and the description in paragraphs 0090 to 0098 of Japanese Patent Laid-Open No. 2019-123809 may be referred to, and the contents thereof are incorporated herein.
The content of the release agent in the resin composition of the present embodiment is preferably 0.01 parts by mass or more, more preferably 0.08 parts by mass or more, and still more preferably 0.2 parts by mass or more, relative to 100 parts by mass of the thermoplastic resin. The upper limit of the content of the release agent is preferably 5 parts by mass or less, more preferably 3 parts by mass or less, still more preferably 1 part by mass or less, and furthermore preferably 0.8 parts by mass or less, relative to 100 parts by mass of the thermoplastic resin.
The resin composition may contain only one release agent, or may contain two or more release agents. In the case where two or more types are included, it is preferable that the total content be within the range.
In the present embodiment, a resin composition for a sub-millimeter wave controller containing a thermoplastic resin, an electrically conductive substance, and a reinforcing material is also disclosed. It is preferable that the electrically conductive material be compounded into a masterbatch. Disclosed is a resin composition for a sub-millimeter wave controller made from, more preferably, at least one thermoplastic resin selected from a polyester resin, a polycarbonate resin and a polystyrene-based resin, a carbon nanotube (preferably a carbon nanotube compounded into a masterbatch with at least one thermoplastic resin selected from a polyester resin and a polystyrene-based resin), and a reinforcing material. On this occasion, it is preferable that the content of the electrically conductive substance (preferably carbon nanotube) be 0.4 to 5.0 mass%. The details are the same as for the resin composition of the present embodiment, and the preferred ranges are also the same.

<Physical properties of resin composition>

The resin composition of the present embodiment has a high absorptance of electromagnetic waves in the sub-millimeter wave region.
Specifically, the resin composition of the present embodiment formed into a molded article with a size of 100 mm $\times$ 100 mm $\times$ t mm thick, provided that t is a value in the case where Concentration C (mass%) of an electrically conductive substance in the resin composition $\times$ Thickness t (mm) gives a value of 1.2 or more, has an absorptance of 35.0% or more at a frequency of 28.0 GHz determined according to formula (A).

Formula (A)

$$\text{Absorptance (\%)} = 100 - \left(\frac{1}{10^{-R/10}} \times 100 + \frac{1}{10^{-T/10}} \times 100\right)$$

wherein R represents the reflection loss measured by a free space method, and T represents the transmission loss measured by a free space method.

The "Concentration C (mass%) of conductive substance × Thickness t (mm)" described above is a value of 1.2 or more, preferably 1.5 or more, more preferably 2.0 or more, and still more preferably 3.0 or more. With a controlled value equal to or more than the lower limit, the electromagnetic wave transmittance of a molded article tends to be lowered. The "Concentration C (mass%) of conductive substance × Thickness t (mm)" described above is a value of preferably 10.0 or less, more preferably 8.0 or less, still more preferably 7.0 or less, furthermore preferably 6.5 or less, and furthermore preferably 6.0 or less. With a controlled value equal to or less than the upper limit, the electromagnetic wave reflectance of a molded article tends to be lowered.

Also, the t described above is preferably 1.0 mm or more, and preferably 4.0 mm or less.

Here, only at least one of the molded articles with a size of 100 mm × 100 mm × t mm thick, provided that t is a value in the case where Concentration C (mass%) of an electrically conductive substance in the resin composition × Thickness t (mm) gives a value of 1.2 or more, formed from the resin composition of the present embodiment, is required to satisfy the Δ absorptance. Moreover, it is not essential to control the thickness to t (mm) in the actual use of the resin composition. However, it is preferable that the actual molded article have a portion with a thickness of t±50%.

The same applies to reflectance, transmittance, Δ absorptance and Δ reflectance hereinafter.

The absorptance is preferably 40.0% or more, more preferably 45.0% or more, still more preferably 50.0% or more, and furthermore preferably 55.0% or more, and furthermore preferably 60.0% or more. Although the upper limit is ideally 100%, the required performance is sufficiently satisfied even with an absorptance of 90.0% or less.

It is preferable that the resin composition of the present embodiment have a low electromagnetic wave reflectance.

Specifically, it is preferable that the resin composition of the present embodiment formed into a molded article with a size of 100 mm × 100 mm × t mm thick, provided that t is a value in the case where Concentration C (mass%) of an electrically conductive substance in the resin composition × Thickness t (mm)) gives a value of 1.2 or more, has a reflectance of 40.0% or less at a frequency of 28.0 GHz determined according to formula (B).

Formula (B)

$$\text{Reflectance (\%)} = \frac{1}{10^{-R/10}} \times 100$$

wherein R represents the reflection loss measured by a free space method.

The reflectance is preferably 35.0% or less, more preferably 30.0% or less, still more preferably 26.0% or less, furthermore preferably 25.0% or less, furthermore preferably 22.0% or less, and furthermore preferably 20.0% or less. Although the lower limit is ideally 0%, the required performance is sufficiently satisfied with a reflectance of 1.0% or more, even with a reflectance of 10.0% or more.

It is preferable that the resin composition of the present embodiment have a low transmittance.

The resin composition of the present embodiment formed into a molded article with a size of 100 mm × 100 mm × t mm thick, provided that t is a value in the case where Concentration C (mass%) of an electrically conductive substance in the resin composition × Thickness t (mm)) gives a value of 1.2 or more, has a transmittance of preferably 45.0% or less, more preferably 30.0% or less, still more preferably 25.0% or less, and furthermore preferably 21.0% or less, determined according to formula (C) at a frequency of 28.0 GHz.

Formula (C)

$$\text{Transmittance (\%)} = \frac{1}{10^{-T/10}} \times 100$$

wherein T represents the transmission loss measured by a free space method.

Although the lower limit of the transmittance is ideally 0%, the required performance is sufficiently satisfied with

a transmittance of 0.1% or more, even with a transmittance of 3.0% or more.

It is preferable that the resin composition of the present embodiment satisfy all of the absorptance determined according to the formula (A), the reflectance determined according to the formula (B), and the transmittance determined according to the formula (C).

The resin composition of the present embodiment formed into a molded article with a size of 100 mm × 100 mm × t mm thick, provided that t is a value in the case where Concentration C (mass%) of an electrically conductive substance in the resin composition × Thickness t (mm)) gives a value of 1.2 or more, has a Δ absorptance, which is the difference between the maximum value and the minimum value of the absorptance determined according to formula (A) in the frequency range of 28.0 GHz to 40.0 GHz, of 20.0% or less.

Formula (A)

$$\text{Absorptance (\%)} = 100 - \left(\frac{1}{10^{-R/10}} \times 100 + \frac{1}{10^{-T/10}} \times 100\right)$$

wherein R represents the reflection loss measured by a free space method, and T represents the transmission loss measured by a free space method.

The Δ absorptance is preferably 17.0% or less, more preferably 10.0% or less, and still more preferably 8.0% or less. Although the lower limit of the Δ absorptance is ideally 0%, the required performance is sufficiently satisfied with a Δ absorptance of 0.5% or more.

Here, the absorptance in the frequency range of 28.0 GHz to 40.0 GHz refers to a measured value measured at 8001 measurement points in the range of frequencies of 25.5 GHz to 41.5 GHz (generally referred to as R band). The same applies to the reflectance and the transmittance.

Further, it is preferable that the resin composition of the present embodiment formed into a molded article with a size of 100 mm × 100 mm × t mm thick, provided that t is a value in the case where Concentration C (mass%) of an electrically conductive substance in the resin composition × Thickness t (mm)) gives a value of 1.2 or more, has a Δ reflectance, which is the difference between the maximum value and the minimum value of the reflectance determined according to formula (B) in the frequency range of 28.0 GHz to 40.0 GHz, of 20.0% or less.

Formula (B)

$$\text{Reflectance (\%)} = \frac{1}{10^{-R/10}} \times 100$$

wherein R represents the reflection loss measured by a free space method.

With a Δ reflectance controlled to be small, the resin composition may be more preferably used for a sub-millimeter wave controller.

The Δ reflectance absorptance is preferably 15.0% or less, more preferably 10.0% or less. Although the lower limit of the Δ reflectance is ideally 0%, the required performance is sufficiently satisfied with a Δ absorptance of 0.5% or more.

<Method for producing resin composition>

The resin composition of the present embodiment may be produced by a conventional method for producing a resin composition containing a thermoplastic resin. For example, the resin composition is produced by melt-kneading a thermoplastic resin and a conductive substance.

Preferably, the resin composition of the present embodiment is produced by feeding a thermoplastic resin (preferably at least one selected from polyester resin, polycarbonate resin and polystyrene-based resin), an electrically conductive material (preferably CNT) made into a master batch with a thermoplastic resin (preferably at least one selected from polyester resin and polystyrene-based resin), and other components blended on an as needed basis into an extruder and melt-kneading the mixture.

Each component may be premixed and supplied to the extruder at once. Alternatively, each component without being premixed or with only a part of the components being premixed may be supplied to the extruder using a feeder. The extruder may be a single screw extruder or a twin screw extruder.

Further, in the case of compounding a reinforcing material (preferably glass fibers), it is preferable that the reinforcing material be supplied from a side feeder in the middle of the cylinder of the extruder.

The heating temperature for melt-kneading may be appropriately selected from the usual range of 170 to 350°C.

<Method for producing molded article>

A molded article, particularly a sub-millimeter wave controller, is formed from the resin composition of the present embodiment.

The molded article in the present embodiment usually has a portion with a thickness of 0.1 mm or more, may have a portion with a thickness of 0.5 mm or more, or may have a thickness of 1.0 mm or more. The molded article in the present embodiment usually has a portion with a thickness of 10.0 mm or less, may have a portion with a thickness of 5.0 mm or less, or may have a portion having a thickness of 3.0 mm or less.

The method for producing a molded article in the present embodiment is not particularly limited, and any forming method commonly used for resin compositions containing a thermoplastic resin may be employed. Examples thereof include injection molding, ultra-high speed injection molding, injection compression molding, two-color molding, hollow molding such as gas assist molding, forming using a heat insulating mold, forming using a rapid heat cycle mold, foam molding (including supercritical fluid), insert molding, IMC (in-mold coating molding) molding, extrusion molding method, sheet molding, thermoforming, rotational molding, laminate molding, press molding, and blow molding, and in particular, injection molding is preferred.

<Application>

The molded article of the present embodiment is formed from the resin composition of the present embodiment. In other words, having high electromagnetic wave absorptance in the sub-millimeter region, the resin composition of the present embodiment and the molded article formed from the resin composition are preferably used for sub-millimeter wave controllers (in particular, as a sub-millimeter wave absorber) . That is, use for an electromagnetic wave controller in the frequency range of 20.0 GHz to 40.0 GHz is more preferred, use for an electromagnetic wave controller in the frequency range of 20.0 GHz to 30.0 GHz is still more preferred, and use for an electromagnetic wave controller at least in the frequency range of 27.0 GHz to 29.0 GHz is furthermore preferred. Such an electromagnetic wave controller is used preferably for 5G communication-related applications and in-vehicle sub-millimeter wave radar applications.

The electromagnetic wave controller of the present embodiment is used for various applications such as fifth generation communication equipment. More specific examples thereof include parts for transmitting various data content for 5G communication such as mobile terminals and PCs, parts for radio base stations and mobile stations, parts for in-vehicle electromagnetic wave communication for automatic or remote driving of automobiles, shark antennas, data communication modules, telematics control units, in-vehicle audio equipment, and car navigation systems. In addition, in order to suppress the irregular reflection of electromagnetic waves inside and outside automobiles, example of various applications of various mechanical parts include in-vehicle radars, ultrasonic sensors, in-vehicle cameras, airbag sensors, electromagnetic control units, power control units, battery management units, inverters, battery components, headlight members, and other automobile interior or exterior members.

In addition, the molded article of the present embodiment is preferably used as sub-millimeter wave radar components including in-vehicle sub-millimeter wave radar for use in an automatic brake control device, inter-vehicle distance control device, steering device for reducing pedestrian accidents, control device for preventing erroneous transmission, acceleration suppression device in case of pedal error, approaching vehicle warning device, lane keeping support device, warning device for preventing rear-end collision, parking support device, and obstacle around vehicle warning device; sub-millimeter wave radar for railroad and aviation for use in platform monitoring/obstacle in railway crossing detection device, content transmission device on a train, tram/train collision prevention device, and device for detecting obstacle on a runway; sub-millimeter wave radar for use in traffic infrastructure such as intersection monitoring device and elevator monitoring device; sub-millimeter wave radar for various security equipment; and sub-millimeter wave radar for medical and nursing care such as systems for monitoring children or aged persons.

[Examples]

The present invention is described more specifically with reference to Examples as follows. The materials, usage amounts, ratios, processing details, processing procedures, etc. shown in the following Examples may be appropriately changed without departing from the subject matter of the present invention. Accordingly, the scope of the present invention is not limited to the specific Examples shown below.

In the case where the measuring instruments and the like used in Examples are hardly available due to discontinued production, other instruments having equivalent performance may be used for the measurement.

1. Raw material

The following raw materials were used. In the following Table 1, HIPS means high impact polystyrene, PBT means polybutylene terephthalate resin, PA means polyamide resin, CNT means carbon nanotube, and MFR means melt flow rate (the same applies to Table 2).

[Table 1]

| Raw material | Symbol | Detail |
|---|---|---|
| (A) Polybutylene terephthalate resin | A-1 | Manufactured by Mitsubishi Engineering-Plastics Corporation, trade name: Novaduran (registered trademark) 5008, intrinsic viscosity: 0.85 dL/g |
| (B) Polystyrene-based resin | B-1 | High impact polystyrene resin (HIPS) manufactured by PS Japan Corporation: HT478, Mw=200000, MFR: 3.2 g/10 minutes |
| (C) Polycarbonate resin | C-1 | polycarbonate resin manufactured by Mitsubishi Engineering-Plastics Corporation, "H-4000", Mv=16000 |
| (D) Masterbatch of electrically conductive substance | D-1 | PBT1501 manufactured by Nanocyl, CNT concentration: 15 mass% |
| | D-2 | HIPS1001 manufactured by Nanocyl, CNT concentration: 10 mass% |
| | D-3 | PA1503 manufactured by Nanocyl, CNT concentration: 15 mass% |
| | D-4 | A masterbatch with 65 mass% of "Novaduran 5510" manufactured by Mitsubishi Engineering-Plastics Corporation, 17 mass% of "PC99-300M" manufactured by Ito Graphite Co., Ltd., and 18 mass% of "EC-50" manufactured by Ito Graphite Co., Ltd. compounded in advance. |
| (E) Stabilizer | E-1 | Thioether-based antioxidant "SEENOX412S" manufactured by Shipro Kasei Kaisha, Ltd. |
| | E-2 | Phosphorus-based transesterification inhibitor, octadecyl acid phosphate, "AX-71" manufactured by ADEKA Corporation |
| (F) Mold release agent | F-1 | Polyethylene-based wax, "Hiwax 100P" manufactured by Mitsui Chemicals, Inc., dropping point: 116°C |
| (G) Epoxy resin | G-1 | Bisphenol A type epoxy resin, "jer1003" manufactured by Mitsubishi Chemical Corporation |
| (H) Reinforcing material | H-1 | Glass fiber manufactured by Nippon Electric Glass Co., Ltd., trade name T-127, including chopped strand glass fibers having a number average fiber diameter of 13 μm treated with novolac type epoxy resin. |

2. Production of resin composition (pellet)

As shown in Table 2, each component shown in Table 1 was placed in a stainless steel tumbler to be mixed and stirred for 1 hour. The resulting mixture was supplied to an intermeshed co-rotation twin screw extruder ("TEX-30α" manufactured by The Japan Steel Works, Ltd., screw diameter: 32 mm, L/D=42) through a main feed port. The barrel temperature of the first kneading unit was set to 260°C, and the reinforcing material (glass fibers) was supplied from a side feeder at the ratio shown in Table 2. The barrel temperature after addition of the reinforcing material was set to 250°C, and the mixture was melt-kneaded under the conditions at a discharge rate of 40 kg/h and a screw rotation speed of 200 rpm, and extruded as a strand through 4 nozzle holes (in circular shape (diameter: 4 mm, length 1.5 cm). The extruded strand was introduced into a water tank to be cooled, and inserted into a pelletizer to be cut. Thereby, a resin composition (pellet) was obtained.

[Table 2]

| | | | Composition 1 | Composition 2 | Composition 3 | Composition 4 |
|---|---|---|---|---|---|---|
| Composition | (A-1) PBT | mass% | 39.4 | 35.1 | 40.8 | 35.1 |
| | (B-1) HIPS | mass% | 19.7 | 20.4 | 11.4 | 20.4 |
| | (C-1) PC | mass% | 6.6 | 6.8 | 6.8 | 6.8 |
| | (D-1) CNT MB | mass% | 3.3 | 6.7 | - | - |
| | (D-2) CNT MB | mass% | - | - | 10.0 | - |
| | (D-3) CNT MB | mass% | - | - | - | 6.7 |
| | (D-4) Graphite MB | mass% | - | - | - | - |
| | (E-1) Stabilizer | mass% | 0.2 | 0.2 | 0.2 | 0.2 |
| | (E-2) Stabilizer | mass% | 0.1 | 0.1 | 0.1 | 0.1 |
| | (F-1) Mold release agent | mass% | 0.2 | 0.2 | 0.2 | 0.2 |
| | (G-1) Epoxy resin | mass% | 0.5 | 0.5 | 0.5 | 0.5 |
| | (H-1) Reinforcing material | mass% | 30.0 | 30.0 | 30.0 | 30.0 |
| | | | | | | |
| | | | Composition 5 | Composition 6 | Composition 7 | Composition 8 |
| Composition | (A-1) PBT | mass% | 32.2 | 28.2 | 22.3 | 61.0 |
| | (B-1) HIPS | mass% | 20.0 | 20.6 | 20.0 | - |
| | (C-1) PC | mass% | 6.8 | 6.9 | 6.8 | - |
| | (D-1) CNT MB | mass% | 10.0 | 13.3 | 20.0 | - |
| | (D-2) CNT MB | mass% | - | - | - | - |
| | (D-3) CNT MB | mass% | - | - | - | - |
| | (D-4) Graphite MB | mass% | - | - | - | 8.0 |
| | (E-1) Stabilizer | mass% | 0.2 | 0.2 | 0.2 | 0.2 |
| | (E-2) Stabilizer | mass% | 0.1 | 0.1 | 0.1 | 0.1 |
| | (F-1) Mold release agent | mass% | 0.2 | 0.2 | 0.2 | 0.2 |
| | (G-1) Epoxy resin | mass% | 0.5 | 0.5 | 0.5 | 0.5 |
| | (H-1) Reinforcing material | mass% | 30.0 | 30.0 | 30.0 | 30.0 |

3. Examples 1 to 8, and Comparative Examples 1 to 3

Using the resulting pellets, injection molding was performed with an injection molding machine ("NEX80" manufactured by Nissei Plastic Industrial Co., Ltd.) with a cylinder temperature at 260°C and a mold temperature at 80°C, so that a test piece having a size of 100 mm × 100 mm × t mm thick (t: thickness shown in Table 3 or Table 4) was obtained. Using the resulting test piece, the absorptance determined according to formula (A), the reflectance determined according to formula (B), and the transmittance determined according to formula (C) at a frequency of 28.0 GHz, and the absorptance determined according to the formula (A) and the reflectance determined according to the formula (B) in the frequency range of 28.0 GHz to 40.0 GHz were obtained. Based on the results obtained, Δ absorptance as the difference between the maximum and minimum values of absorptance, and Δ reflectance as the difference between the maximum and minimum values of reflectance were measured.

Here, the absorptance in the frequency range of 28.0 GHz to 40.0 GHz refers to a measured value obtained from 8001 measurement points in the range of frequencies of 25.5 GHz to 41.5 GHz (generally referred to as R band). The same applies to the reflectance and the transmittance.

A network analyzer "N5290A" manufactured by Keysight Technologies Inc. was used for the measurement.

In the measurement, the test piece was placed such that TD (transverse direction) of the injected molding was parallel to the direction of the electric field.

Formula (A)

$$\text{Absorptance (\%)} = 100 - \left(\frac{1}{10^{-R/10}} \times 100 + \frac{1}{10^{-T/10}} \times 100\right)$$

wherein R represents the reflection loss measured by a free space method, and T represents the transmission loss measured by a free space method.

Formula (B)

$$\text{Reflectance (\%)} = \frac{1}{10^{-R/10}} \times 100$$

wherein R represents the reflection loss measured by a free space method.

Formula (C)

Formula (C)

$$\text{Transmittance (\%)} = \frac{1}{10^{-T/10}} \times 100$$

wherein T represents the transmission loss measured by a free space method.

<Evaluation of electromagnetic wave absorbability>

The electromagnetic wave absorptance at a frequency of 28.0 GHz, the electromagnetic wave reflectance at a frequency of 28.0 GHz, the electromagnetic wave transmittance at the frequency of 28.0 GHz, the Δ absorptance and the Δ reflectance were comprehensively taken into consideration to evaluate the electromagnetic wave absorbability. The rating 5 is the best.

5: All of the following items (1) to (5) are satisfied.
4: Any four of the following items (1) to (5) are satisfied.
3: Any three of the following items (1) to (5) are satisfied.
2: Any two of the following items (1) to (5) are satisfied.
1: Any one of the following items (1) to (5) is satisfied. Alternatively, none of them are satisfied.

(1) The absorptance is 40.0% or more.
(2) The reflectance is 40.0% or less
(3) The transmittance is 21.0% or less
(4) The Δ absorptance is 20.0% or less
(5) The Δ reflectance is 20.0% or less

[Table 3]

| | | Unit | Example 1 | Example 2 | Example 3 |
|---|---|---|---|---|---|
| Resin composition | | - | Composition 1 | Composition 5 | Composition 2 |
| | Concentration of electrically conductive substance (C) | mass% | 0.5 | 1.5 | 1.0 |
| | Thickness of sample (t) | mm | 3.0 | 2.0 | 2.0 |
| | Concentration C × Thickness t | - | 1.5 | 3.0 | 2.0 |
| Evaluation | Absorptance of electromagnetic waves at 28.0 GHz | % | 46.5 | 68.3 | 55.1 |
| | Reflectance of electromagnetic waves at 28.0 GHz | % | 17.3 | 11.6 | 4.2 |
| | Transmittance of electromagnetic waves at 28.0 GHz | % | 36.2 | 20.1 | 40.7 |
| | Δ Absorptance | % | 18.0 | 4.4 | 4.1 |
| | Δ Reflectance | % | 12.6 | 12.8 | 18.7 |
| | Evaluation of electromagnetic wave absorbability | - | 4 | 5 | 4 |
| | | | | | |
| | | Unit | Example 4 | Example 5 | Example 6 |
| Resin composition | | - | Composition 2 | Composition 3 | Composition 6 |
| | Concentration of electrically conductive substance (C) | mass% | 1.0 | 1.0 | 2.0 |
| | Thickness of sample (t) | mm | 3.0 | 3.0 | 2.0 |
| | Concentration C × Thickness t | - | 3.0 | 3.0 | 4.0 |
| Evaluation | Absorptance of electromagnetic waves at 28.0 GHz | % | 69.4 | 73.9 | 66.7 |
| | Reflectance of electromagnetic waves at 28.0 GHz | % | 19.9 | 20.2 | 22.2 |
| | Transmittance of electromagnetic waves at 28.0 GHz | % | 10.8 | 5.9 | 11.1 |
| | Δ Absorptance | % | 5.0 | 3.7 | 2.6 |
| | Δ Reflectance | % | 9.2 | 6.7 | 6.5 |
| | Evaluation of electromagnetic wave absorbability | - | 5 | 5 | 5 |

[Table 4]

| | | Unit | Example 7 | Example 8 |
|---|---|---|---|---|
| Resin composition | | - | Composition 7 | Composition 7 |
| | Concentration of electrically conductive substance (C) | mass% | 3.0 | 3.0 |
| | Thickness of sample (t) | mm | 2.0 | 3.0 |
| | Concentration C × Thickness t | - | 6.0 | 9.0 |
| Evaluation | Absorptance of electromagnetic waves at 28.0 GHz | % | 65.5 | 54.9 |
| | Reflectance of electromagnetic waves at 28.0 GHz | % | 31.9 | 44.8 |
| | Transmittance of electromagnetic waves at 28.0 GHz | % | 2.6 | 0.2 |
| | Δ Absorptance | % | 7.3 | 2.5 |
| | Δ Reflectance | % | 9.2 | 2.3 |
| | Evaluation of electromagnetic wave absorbability | - | 5 | 4 |

| | | Unit | Comparative Example 1 | Comparative Example 2 | Comparative Example 3 |
|---|---|---|---|---|---|
| Resin composition | | - | Composition 1 | Composition 8 | Composition 4 |
| | Concentration of electrically conductive substance (C) | mass% | 0.5 | 2.8 | 1.0 |
| | Thickness of sample (t) | mm | 2.0 | 2.0 | 3.0 |
| | Concentration C × Thickness t | - | 1.0 | 5.6 | 3.0 |

(continued)

| | | Unit | Comparative Example 1 | Comparative Example 2 | Comparative Example 3 |
|---|---|---|---|---|---|
| Resin composition | | - | Composition 1 | Composition 8 | Composition 4 |
| Evaluation | Absorptance of electromagnetic waves at 28.0 GHz | % | 28.5 | 6.5 | 35.7 |
| | Reflectance of electromagnetic waves at 28.0 GHz | % | 9.3 | 8.6 | 27.3 |
| | Transmittance of electromagnetic waves at 28.0 GHz | % | 62.1 | 84.8 | 37.0 |
| | Δ Absorptance | % | 10.8 | 2.1 | 21.4 |
| | Δ Reflectance | % | 21.2 | 31.6 | 21.9 |
| | Evaluation of electromagnetic wave absorbability | - | 2 | 1 | 1 |

As is shown in the results, the resin composition of the present invention was excellent in electromagnetic wave absorbability of the sub-millimeter waves. Further, in the sub-millimeter wave region, the fluctuations of the absorptance and reflectance were small. In other words, the frequency dependence in the sub-millimeter wave region was small.

## Claims

**1.** A resin composition comprising a thermoplastic resin and an electrically conductive substance,

wherein the resin composition formed into a molded article with a size of 100 mm × 100 mm × t mm thick, provided that t is a value in a case where Concentration C (mass%) of an electrically conductive substance in the resin composition × Thickness t (mm) gives a value of 1.2 or more, has a Δ absorptance of 20.0% or less, which is a difference between a maximum value and a minimum value of the absorptance determined according to formula (A) in the frequency range of 28.0 GHz to 40.0 GHz; and
has the absorptance of 35.0% or more at a frequency of 28.0 GHz determined according to the formula (A):

Formula (A)

$$\text{Absorptance (\%)} = 100 - \left(\frac{1}{10^{-R/10}} \times 100 + \frac{1}{10^{-T/10}} \times 100\right)$$

wherein R represents the reflection loss measured by a free space method, and T represents the transmission loss measured by a free space method.

**2.** The resin composition according to claim 1,

wherein the resin composition formed into a molded article with a size of 100 mm × 100 mm × t mm thick, provided that t is a value in a case where Concentration C (mass%) of an electrically conductive substance in the resin composition × Thickness t (mm) gives a value of 1.2 or more, has a Δ reflectance of 20.0% or less, which is a difference between a maximum value and a minimum value of the reflectance determined according to formula (B) in the frequency range of 28.0 GHz to 40.0 GHz:

Formula (B)

$$\text{Reflectance (\%)} = \frac{1}{10^{-R/10}} \times 100$$

wherein R represents the reflection loss measured by a free space method.

3. The resin composition according to claim 1 or 2, wherein the resin composition formed into a molded article with a size of 100 mm × 100 mm × t mm thick, provided that t is a value in a case where Concentration C (mass%) of an electrically conductive substance in the resin composition × Thickness t (mm) gives a value of 1.2 or more, has a reflectance of 40.0% or less determined according to formula (B) at a frequency of 28.0 GHz:

Formula (B)

$$\text{Reflectance (\%)} = \frac{1}{10^{-R/10}} \times 100$$

wherein R represents the reflection loss measured by a free space method.

4. The resin composition according to any one of claims 1 to 3, wherein the resin composition formed into a molded article with a size of 100 mm × 100 mm × t mm thick, provided that t is a value in a case where Concentration C (mass%) of an electrically conductive substance in the resin composition × Thickness t (mm) gives a value of 1.2 or more, has a transmittance of 21.0% or less determined according to formula (C) at a frequency of 28.0 GHz:

Formula (C)

$$\text{Transmittance (\%)} = \frac{1}{10^{-T/10}} \times 100$$

provided that t represents the transmission loss measured by a free space method.

5. The resin composition according to any one of claims 1 to 4, wherein the absorptance is 40.0% or more determined according to formula (A) at a frequency of 28.0 GHz.

6. The resin composition according to any one of claims 1 to 5, wherein the electrically conductive substance comprises a carbon nanotube.

7. The resin composition according to any one of claims 1 to 6, wherein the thermoplastic resin comprises at least one selected from the group consisting of a polyester resin, a polycarbonate resin and a polystyrene-based resin.

8. The resin composition according to any one of claims 1 to 6, wherein the thermoplastic resin comprises a polybutylene terephthalate resin.

9. The resin composition according to any one of claims 1 to 8, wherein a part of the thermoplastic resin is derived from a masterbatch of the electrically conductive substance.

10. The resin composition according to claim 9, wherein the thermoplastic resin derived from the masterbatch comprises at least one selected from the group consisting of a polyester resin and a polystyrene-based resin.

11. The resin composition according to any one of claims 1 to 10, wherein the concentration of the electrically conductive substance in the resin composition is 0.01 to 10.0 mass%.

12. The resin composition according to any one of claims 1 to 11, further comprising a reinforcing material at ratio of 5.0 to 60.0 mass%.

13. The resin composition according to any one of claims 1 to 12, further comprising a reactive compound at ratio of 0.1 to 10.0 mass%.

14. The resin composition according to any one of claims 1 to 13, wherein the resin composition formed into a molded article with a size of 100 mm × 100 mm × t mm thick, provided that t is a value in a case where Concentration C (mass%) of an electrically conductive substance in the resin composition × Thickness t (mm) gives a value of 3.0 to 6.0, has a Δ absorptance of 20.0% or less, which is a difference between a maximum value and a minimum value of the absorptance determined according to formula (A) in the frequency range of 28.0 GHz to 40.0 GHz, and an absorptance of 35.0% or more at a frequency of 28.0 GHz determined according to the formula (A).

15. The resin composition according to any one of claims 1 to 14, for use in a sub-millimeter wave controller.

16. A resin composition for a sub-millimeter wave controller comprising at least one thermoplastic resin selected from the group consisting of a polyester resin, a polycarbonate resin and a polystyrene-based resin, a carbon nanotube, and a reinforcing material, wherein a content of the carbon nanotube is 0.4 to 5.0 mass%.

17. A molded article formed from the resin composition according to any one of claims 1 to 16.

18. The molded article according to claim 17, which is for a sub-millimeter wave controller.

## INTERNATIONAL SEARCH REPORT

International application No.
**PCT/JP2022/012542**

**A. CLASSIFICATION OF SUBJECT MATTER**

***C08J 5/00***(2006.01)i; ***C08K 3/04***(2006.01)i; ***C08L 101/00***(2006.01)i; ***H05K 9/00***(2006.01)i
FI: C08J5/00 CEZ; C08K3/04; C08L101/00; H05K9/00 X; H05K9/00 M

According to International Patent Classification (IPC) or to both national classification and IPC

**B. FIELDS SEARCHED**

Minimum documentation searched (classification system followed by classification symbols)

C08J5/00; C08K3/04; C08L101/00; H05K9/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP 2016-504471 A (LG CHEMICAL LTD.) 12 February 2016 (2016-02-12) whole document, particularly, claims, paragraphs [0014]-[0070] | 1-8, 11, 12, 14-18<br>9, 10, 13 |
| Y | WO 2014/002581 A1 (KREFINE CO., LTD.) 03 January 2014 (2014-01-03) whole document, particularly, claims, paragraphs [0030]-[0049], [0065]-[0093] | 9, 10, 13 |
| A | JP 2011-184681 A (TOYOTA CENTRAL R&D LABS., INC.) 22 September 2011 (2011-09-22) whole document | 1-18 |
| A | JP 2017-507211 A (LG CHEMICAL LTD.) 16 March 2017 (2017-03-16) whole document | 1-18 |
| A | WO 2019/235561 A1 (MICROWAVE ABSORBERS INC.) 12 December 2019 (2019-12-12) whole document | 1-18 |
| A | JP 2017-512847 A (LG CHEMICAL LTD.) 25 May 2017 (2017-05-25) whole document | 1-18 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **27 April 2022** | **17 May 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2022/012542**

**C. DOCUMENTS CONSIDERED TO BE RELEVANT**

| Category* | Citation of document, with indication, where appropriate, of the relevant passages | Relevant to claim No. |
|---|---|---|
| P, A | JP 2021-130795 A (POLYPLASTICS CO.) 09 September 2021 (2021-09-09) whole document | 1-18 |
| P, A | JP 6927448 B1 (TOYO INK SC HOLDINGS CO., LTD.) 01 September 2021 (2021-09-01) whole document | 1-18 |
| P, A | JP 7004106 B1 (TOYO INK SC HOLDINGS CO., LTD.) 10 February 2022 (2022-02-10) whole document | 1-18 |

Form PCT/ISA/210 (second sheet) (January 2015)

**INTERNATIONAL SEARCH REPORT**
**Information on patent family members**

International application No.
**PCT/JP2022/012542**

| Patent document cited in search report | Publication date (day/month/year) | Patent family member(s) | Publication date (day/month/year) |
|---|---|---|---|
| JP 2016-504471 A | 12 February 2016 | US 2016/0355670 A1<br>whole document, particularly, claims, paragraphs [0015]-[0084]<br>WO 2015/084110 A1<br>EP 2902443 A1<br>KR 10-2015-0066480 A<br>CN 104837926 A | |
| WO 2014/002581 A1 | 03 January 2014 | TW 201404813 A | |
| JP 2011-184681 A | 22 September 2011 | (Family: none) | |
| JP 2017-507211 A | 16 March 2017 | US 2017/0190884 A1<br>EP 3239225 A1<br>KR 10-2016-0079725 A<br>CN 106103567 A | |
| WO 2019/235561 A1 | 12 December 2019 | (Family: none) | |
| JP 2017-512847 A | 25 May 2017 | US 2017/0066907 A1<br>WO 2016/032307 A1<br>EP 3187526 A1<br>KR 10-2016-0026805 A<br>CN 106164151 A | |
| JP 2021-130795 A | 09 September 2021 | (Family: none) | |
| JP 6927448 B1 | 01 September 2021 | (Family: none) | |
| JP 7004106 B1 | 10 February 2022 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003243878 A
- JP 2010174223 A
- JP 2005344065 A
- JP 2011132550 A
- JP 2018070722 A
- JP 2019056035 A
- WO 2017038949 A
- JP 2013007058 A
- JP 2019123809 A